(19) Europäisches Patentamt
European Patent Office
Office européen des brevets

(11) EP 4 660 639 A1

(12) EUROPEAN PATENT APPLICATION

(43) Date of publication:
10.12.2025 Bulletin 2025/50

(21) Application number: 24179958.4

(22) Date of filing: 04.06.2024

(51) International Patent Classification (IPC):
G01R 29/08 (2006.01)    H04B 10/00 (2013.01)

(52) Cooperative Patent Classification (CPC):
G01R 29/0885; H04B 2210/006

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: British Telecommunications public
limited company
London E1 8EE (GB)

(72) Inventors:
• SUN, Qiushuo
London
E1 8EE (GB)
• SINGH, Alok
London
E1 8EE (GB)
• GOLKS, Daniel
London
E1 8EE (GB)

(74) Representative: British Telecommunications
public limited company
Intellectual Property Department
9th Floor
One Braham
Braham Street
London E1 8EE (GB)

(54) ELECTROMAGENTIC FIELD DETECTOR

(57) An apparatus (100) for detecting an Electro-Magnetic, EM, field, said apparatus comprising a: Rydberg-Atom EM Field Detector (107), RAEM-FD, configured to detect an EM field (170) of a given frequency; and Multi-Plate WaveGuide (105), MPWG, comprising: at least three overlapping and non-intersecting plates (180); and at least two waveguides (190), each formed by an adjacent pair of the at least three plates, and wherein each waveguide has a separation distance suitable (h) for supporting propagation of the EM field; and wherein the MPWG is arranged so as to direct the EM field towards the RAEM-FD.

Figure 1

EP 4 660 639 A1

## Description

Field of Invention

The present invention relates to an Electro-Magnetic (EM) field detector, and in particular comprising a Rydberg-Atom EM Field Detector (RAEM-FD) coupled with a Multi-Plate WaveGuide.

Background

In wireless telecommunications, a transmitted wireless signal will decrease in signal strength with distance from a transmission source, for example due to scattering, reflection and propagation losses. Beyond a sensitivity threshold of a wireless receiver, the wireless signal cannot be detected above a background noise level at the receiver. As a result, extrinsic background noise, or the noise floor of the receiving apparatus dominates.

The detection threshold of a wireless receiver places undesirable constraints upon effective wireless telecommunications, and in particular upon range, capacity, and energy-efficiency of the physical layer of radio-based communication.

It is an aim of the present invention to alleviate at least some of the aforementioned problems.

Statements of Invention

According to a first aspect of the present invention, there is provided: an apparatus for detecting an Electro-Magnetic, EM, field, said apparatus comprising a: Rydberg-Atom EM Field Detector, RAEM-FD, configured to detect an EM field of a given frequency; and Multi-Plate WaveGuide, MPWG, comprising: at least three overlapping and non-intersecting plates; and at least two waveguides, each formed by an adjacent pair of the at least three plates, and wherein each waveguide has a separation distance suitable for supporting propagation of the EM field; and wherein the MPWG is arranged so as to direct the EM field towards the RAEM-FD.

Preferably, each of the at least three plates are formed of an electrically conductive material. Preferably, said plates comprise a metal (including a metal alloy), which may in turn consist of or comprise: Aluminium; Copper; Gold; Titanium; Silver; Nickel; Platinum; Tin; and/or Zinc. Preferably, each of the at least three plates is formed as a monolithic metal plate (or sheet). Preferably, the at least two waveguides share a common plate. Preferably, the RAEM-FD is configured to detect the EM field by exploiting Electromagnetically Induced Transparency. Preferably, the RAEM-FD comprises a/an: container (e.g. a vapour cell) comprising a medium of Rydberg atoms; probe laser configured to transmit a probe signal through the vapour cell; coupling laser configured to transmit a coupling signal into the vapour cell and in counter propagation to the probe signal; and a photodetector configured to receive the probe signal having been transmitted through the vapour cell. Preferably, the medium of Rydberg atoms comprises or consists of an alkali or alkali earth metal, and more preferably Rubidium or Caesium. Optionally, at least one, or all, of the waveguides consist/s of a vacuum or a dielectric medium arranged therebetween (at least within a corresponding overlapping region), and the dielectric medium may be air or water.

Preferably, the at least two waveguides are configured such that the separation distances decrease with successive waveguides, thereby to configure the MPWG as a stepped-index convergent lens having a focus for the given frequency, and wherein the MPWG is arranged so that the focus is coincident upon the RAEM-FD. Preferably, the separation distances decrease with each successive adjacent waveguide. Preferably, the separation distances decrease monotonically or continuously with (e.g. each) successive waveguide. Preferably, the MPWG comprises at least three waveguides. Preferably, the at least three waveguides comprise a centremost (or an innermost) one or two of said waveguides. Preferably, the at least three waveguides comprise two outermost waveguides. Preferably, the at least three waveguides comprise one or two waveguide/s having a greatest separation distance, and more preferably the innermost waveguide/s have said greatest separation distance. Preferably, the MPWG is arranged so that the focus is coincident upon the container of the RAEM-FD. Preferably, the focus is coincident upon a geometric centre of the container.

Preferably, the at least two waveguides plates are configured such that the separation distances increase with successive waveguides, thereby to configure the MPWG as a stepped-index divergent lens. Preferably, the separation distances increase monotonically, and more preferably with each successive adjacent waveguide. Preferably, at least two, and optionally all, of the at least two waveguides each have a separation distance that provides a waveguide cut-off frequency at least equal to the given frequency, and more preferably at least for Transverse Electric (TE) mode propagation. Preferably, at least two, and optionally all, of the at least two waveguides have a width (said width preferably extending parallel to the corresponding adjacent plates and perpendicularly to the propagation of the EM field within the corresponding waveguide) at least equal to the corresponding wavelength of the given frequency. Preferably, at least two of, and optionally all of, the at least two waveguides have a depth (said depth preferably being perpendicular to the width and perpendicular to the propagation of the EM field within the corresponding waveguide) at least equal to the corresponding wavelength. Preferably, at least two of, and optionally all of, the waveguides have a separation distance at least equal to, and more preferably at least one-and-a-half times, and still more preferably at least twice, the corresponding wavelength. As used herein, the term "overlapping" preferably connotes at least a portion of an adjacent pair of the plates coinciding along an axis in which said plates are stacked. Optionally, some, or all, of the plates fully or partially overlap. Optionally, all of plates are mutually overlapping. Preferably, the separation distances are all non-zero. Optionally, all separation distances are different. Preferably, the separation distances decrease or increase from the centremost to the outmost waveguides. Preferably, the separation distances decrease or increase for each and every adjacent waveguide. Preferably, the separation distances decrease according to a parabolic, hyperbolic, ellipsoid or spherical function. Optionally, the MPWG is symmetric (at least as to separation distances) about the centremost waveguide/s and/or about a single or pair of waveguide/s having the greatest separation distance. Preferably, the MPWG is aligned (and, more preferably, centred), in a direction of propagation of the EM field through the MPWG, relative to the RAEM-FD. Preferably, the centremost waveguide/s is/are aligned (and, more preferably, centred) with the RAEM-FD, and still more preferably with the container. Preferably, each of the plates are flat.

Preferably, the separation distances are equal for at least two of the at least two waveguides. Optionally, all of the at least two waveguides have equal separation distances. Optionally, there are provided at least three waveguides, and at least two, but not all, of the at least three waveguides, have equal separation distances. Optionally, the separation distances for the centremost plates are equal.

Preferably, all, or at least two, of the at least three plates are mutually parallel. Optionally, the MPWG comprises at least four plates, and wherein at least two of said plates are non-parallel. Preferably, the at least two non-parallel plates comprise an adjacent pair of non-parallel plates. Preferably, the adjacent pair of non-parallel plates are arranged such that a largest and smallest separation distance therebetween is orientated most distally and most proximately the RAEM-FD, respectively.

Preferably, the apparatus further comprises an actuation mechanism, said mechanism in turn comprising at least one of a: first actuator configured to move at least one of the at least three plates so as to change the separation distance of at least one of the at least two waveguides that is associated with said at least one plate; and second actuator configured bodily to move the MPWG and/or the RAEM-FD so as to change a spacing therebetween along an axis parallel to the propagation of the EM field through the MPWG. Optionally, the first actuator is configured simultaneously to change the separation distance of at least two, or all, of the at least three plates. Optionally, the first actuator is configured to change the separation distance of at least two, or all, of the at least two waveguides. Optionally, the first actuator is configured to apply the same absolute or relative change in separation distance to each of said at least two or all waveguides. Optionally, the first actuator is configured to apply a different absolute or relative change in separation distance to each of said at least two or all waveguides. Optionally, the second actuator is configured to translate the MPWG and/or the RAEM-FD only along said axis.

Preferably, the apparatus further comprises a controller configured to tune the RAEM-FD to detect a further EM field of a further given frequency, different to the given frequency, and wherein the controller is further configured responsively to operate the actuation mechanism so as to reconfigure the apparatus so as to direct the further EM field towards the RAEM-FD. Preferably, the controller is configured to decrease a waveguide cut-off frequency of the MPWG (or at least one of the waveguides) so as to be equal to or less than the further given frequency. Preferably, the controller is configured to tune the RAEM-FD by reconfiguring the probe laser to change a frequency of the probe signal so as to induce an atomic transition in the vapour cell that permits detection of the further given frequency.

Preferably, the controller is configured to operate the actuation mechanism so as to focus the further EM field upon the RAEM-FD. Optionally, the controller is further configured to operate the actuation mechanism so as to reconfigure the apparatus so as to misdirect or block the further EM field from the RAEM-FD. Optionally, the controller is configured to increase a waveguide cut-off frequency of the MPWG (or at least one of the waveguides) so as to be equal to or greater than the further given frequency. Optionally, controller is configured to operate the actuation mechanism so as to defocus the further EM field from the RAEM-FD.

Preferably, the controller is configured to receive, from the RAEM-FD, a reading of signal strength for the further EM-field, and wherein the controller is configured to operate the actuation mechanism in dependence upon increasing said received signal strength.

According to another aspect of the invention, there is provided a radio receiver for a wireless telecommunications network comprising the apparatus as described above. Optionally, the radio receiver is for, and the wireless telecommunications is, a: wide area network; cellular network; microwave communication network; wireless local area network; and/or satellite network. The radio receiver may be a base station or an access point.

According to another aspect of the invention, there is provided a radiodetermination system comprising an apparatus as described above. Preferably, said radiodetermination system comprises a radar detection, location, and/or navigation system.

According to another aspect of the invention, there is provided a medical imaging device or system comprising an apparatus as described above. Preferably, said device or system comprises a Magnetic Resonance Imaging and/or Magnetic Resonance Spectroscopy device or system.

According to another aspect of the invention, there is provided a composition analysis instrument comprising an apparatus as described above. Preferably, said instrument is a Nuclear Magnetic Resonance (NMR) spectrometer. According to another aspect of the invention, there is provided a radio-imaging system comprising an imaging array of the apparatus described above.

According to yet another aspect of the invention, there is provided a method of operating an apparatus for detecting an Electro-Magnetic, EM, field, said apparatus comprising a/an: Rydberg-Atom EM Field Detector (RAEM-FD) configured to detect an EM field of a given frequency; Multi-Plate WaveGuide, MPWG, comprising: at least three overlapping and non-intersecting plates; and at least two waveguides, each formed by an adjacent pair of the at least three plates, and wherein each waveguide has a separation distance suitable for supporting propagation of the EM field, wherein the MPWG is arranged so as to direct the EM field towards the RAEM-FD; actuation mechanism comprising at least one of a: first actuator configured to move at least one of the at least three plates so as to change the separation distance of at least one of the at least two waveguides that is associated with said at least one plate; and second actuator configured bodily to move the MPWG and/or the RAEM-FD so as to change a spacing therebetween along an axis parallel to the propagation of the EM field through the MPWG; and controller configured to tune the RAEM-FD to detect a further EM field of a further given frequency, different to the given frequency, and wherein the controller is further configured to operate the actuation mechanism so as to reconfigure the apparatus so as to direct the further EM field towards the RAEM-FD; the method comprising the steps of: providing the RAEM-FD in a first condition suitable for detecting the given frequency; providing the first actuator and/or the second actuator in a first state suitable for directing the EM field towards the RAEM-FD; re-turning, by the controller, the RAEM-FD into a second conditions suitable for detecting the further given frequency; and re-configuring, by the controller and in response to said re-tuning, the first actuator and/or the second actuator into a second state suitable for directing the further EM field towards the RAEM-FD.

According to still another aspect of the invention, there is provided a computer-readable carrier medium comprising a computer program, which, when the computer program is executed by a computer, causes the computer to carry out the method as described above.

According to another aspect of the invention, there is provided: an apparatus for detecting an EM field comprising a: Rydberg-Atom Electro-Magnetic Field Detector (RAEM-FD); and Multi-Plate WaveGuide, MPWG, comprising a plurality of parallel plates wherein a respective separation distance between each pair of adjacent parallel plates of the plurality of parallel plates is configured such that a respective refractive index of said pair of adjacent parallel plates cooperate to focus an incoming electromagnetic field at a first focal point, and wherein the RAEM-FD is positioned at the first focal point. Preferably, the plurality of parallel plates comprises a first pair of adjacent parallel plates and a second pair of adjacent parallel plates, the first and second pairs of adjacent parallel plates having configured respective separation distances such that the respective refractive index of the first and second pairs of adjacent parallel plates cooperate to focus the incoming electromagnetic field at the first focal point. Preferably, the plurality of parallel plates comprises a central pair of adjacent parallel plates, a first outermost pair of adjacent parallel plates and a second outermost pair of adjacent parallel plates, wherein the respective separation distance of each pair of adjacent parallel plates monotonically decreases from the central pair of adjacent parallel plates to the first and second outermost pairs of adjacent parallel plates. Preferably, the respective separation distance of each pair of adjacent parallel plates is reconfigurable such that a respective refractive index of each pair of adjacent parallel plates cooperate to focus an incoming electromagnetic field of a predetermined frequency at the first focal point.

The above summary is not intended to describe each illustrated embodiment or every implementation of the subject matter hereof. The invention includes any novel aspects described and/or illustrated herein. The invention also extends to methods and/or apparatus substantially as herein described and/or as illustrated with reference to the accompanying drawings. The invention is also provided as a computer program and/or a computer program product for carrying out any of the methods described herein and/or for embodying any of the apparatus features described herein, and a computer-readable medium storing thereon a program for carrying out any of the methods and/or for embodying any of the apparatus features described herein. Features described as being implemented in hardware may alternatively be implemented in software, and vice versa.

It should be understood that the individual operations used in the methods of the present teachings may be performed in any order and/or simultaneously, as long as the teaching remains operable. Furthermore, it should be understood that the apparatus and methods of the present teachings can include any number, or all, of the described embodiments, as long as the teaching remains operable.

Any apparatus feature may also be provided as a corresponding step of a method, and vice versa. As used herein, means plus function features may alternatively be expressed in terms of their corresponding structure, for example as a suitably-programmed processor.

Any feature in one aspect of the invention may be applied, in any appropriate combination, to other aspects of the invention. Any, some and/or all features in one aspect can be applied to any, some and/or all features in any other aspect, in any appropriate combination. Particular combinations of the various features described and defined in any aspects of the invention can be implemented and/or supplied and/or used independently.

As used throughout, the word 'or' can be interpreted in the exclusive and/or inclusive sense, unless otherwise specified.

The invention extends to an apparatus for detecting an Electro-Magnetic, EM, field, a method of operating the same, and a radio receiver comprising the apparatus, as described herein and/or substantially as illustrated with reference to the accompanying drawings. The present invention is now described, purely by way of example, with reference to the accompanying diagrammatic drawings, in which:

Figure 1 is a schematic of an EM field detector comprising a waveguide;
Figures 2a and 2b show, in detail, a first example of the waveguide;
Figure 3 is a plot performance of the first example of the waveguide;
Figures 4a and 4b show, in detail, a second example of the waveguide;
Figures 5a and 5b show, in detail, a third example of the waveguide;
Figure 6 shows a process of operating the second and third examples of the waveguide; and
Figure 7 shows, in detail, a fourth example of the waveguide.

While various embodiments are amenable to various modifications and alternative forms, specifics thereof have been shown by way of example in the drawings and will be described in detail. It should be understood, however, that the intention is not to limit the claimed inventions to the particular embodiments described. On the contrary, the intention is to cover all modifications, equivalents, and alternatives falling within the spirit and scope of the subject matter as defined by, at least, the claims.

Specific Description

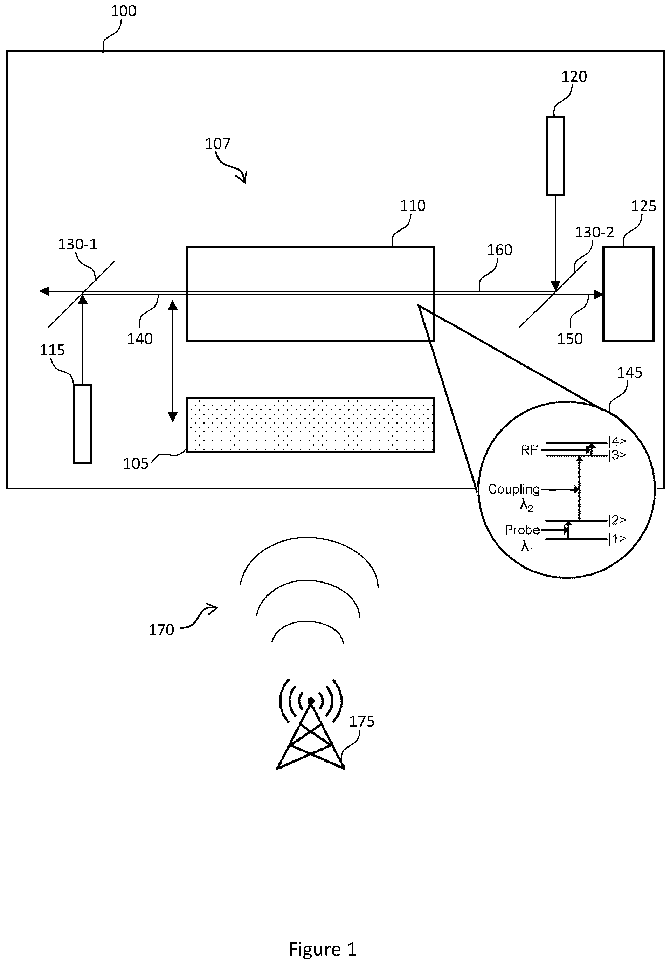

Figure 1 schematically shows an apparatus in the form of an Electro-Magnetic (EM) field detector 100 comprising a: Multi-Plate WaveGuide (MPWG) 105; and Rydberg-Atom EM Field Detector (herein "RAEM-FD") 107.

The RAEM-FD 107 (also known as an "atomic receiver" or a "quantum optical receiver") in turn comprises a: Rydberg vapour cell 110; probe laser 115; coupling laser 120; photodetector 125; and a set of beamsplitters (*e.g.* dichroic mirrors) 130, comprising a first beamsplitter 130-1 and a second beamsplitter 130-2.

The Rydberg vapour cell 110 comprises a container (*e.g.* a sealed glass, ceramic or Perspex vessel) containing a low-density vaporous medium of Rydberg atoms, such as alkali metal (*e.g.* Rubidium-85 or Caesium-55) or alkaline earth metal atoms (*e.g.* Strontium-88).

A Rydberg atom is an atom with at least one electron excited to a very high principal quantum number ($n \gg 1$). Rydberg atoms experience very large dipole moments and long decay periods; these characteristics are exploited by the RAEM-FD 107 so as to receive and demodulate EM fields over very large frequency ranges (compared to conventional conductive antennas), typically between so-called (as defined by the International Telecommunication Union) medium and super high frequencies (*e.g.* between 1MHz and 30GHz), but as low as extremely low frequencies, and as high as infrared frequencies (*e.g.* between 3Hz and 1THz), in some examples. For conciseness, as used herein, the terms "radio" and "radio frequency" include, in addition to conventional radio frequencies, far infrared frequencies that are known to be detectable by a suitably configured RAEM-FD.

Each Rydberg atom has a ground state and a plurality of excited states, which may be excited (*i.e.* by absorbing a photon of sufficient energy that permits electron transition) from the ground state to an excited state. The electron then transitions by decay from the excited state to a lower excited state (*i.e.* an excited state at a lower energy level) or to the ground state, with certain transitions being unpermitted because they are dipole forbidden.

The probe laser 115 is configured and arranged to transmit - via the first beamsplitter 130-1 - a probe signal 140 through the Rydberg vapour cell 110, and thus the constituent Rydberg atoms (*e.g.* Rb-85), in which the probe signal is at a first wavelength (*e.g.* ≈780nm), $\lambda_1$, corresponding to an energy required to elevate an outer electron of the Rydberg atoms from a ground state (|1>) to a first excited state (|2>); this transition is shown in the electron transition diagram 145 in Figure 1. The probe signal that emerges from the Rydberg vapour cell 110 is referred to as the output signal 150 and is effectively used to detect an EM field 170 (*e.g.* a radio-frequency signal) from an EM source 175 (*e.g.* a cellular base station), as described below in more detail.

Simultaneously, the coupling laser 120 is configured and arranged to transmit - via the second beamsplitter 130-2 - a coupling signal 160 through the Rydberg vapour cell 110 in counter-propagation (to help reduce Doppler shifting) to, and overlapping with, the probe signal 140, in which the coupling signal 160 is at a second wavelength (*e.g.* ≈480nm), $\lambda_2$, corresponding to an energy required to elevate the outer electron of the Rydberg atoms from the first excited state (|2>) to a Rydberg state (|3>), and having greater power than the probe signal. The transition from the first excited state (|2>) to the Rydberg state (|3>) is also shown in the electron transition diagram 145 in Figure 1. Accordingly, a three-level atomic system is created. To help (further) reduce Doppler shifting, the probe 115 and coupling 120 lasers are frequency stabilised.

In a quantum optical and quantum interference process known as Electromagnetically Induced Transparency (EIT), two excitation paths (*e.g.* 11 > → 12> and | 2>→|3> interfere destructively and create a transparency window for the probe signal 140 operating at $\lambda_1$. For example, in an EIT ladder scheme, transition from the Rydberg state (13)) to the ground state (|1>) is forbidden, the ground state (|1>) becomes depopulated and so fewer atoms can absorb the probe signal 140. Accordingly, the Rydberg atoms become more transparent to the probe signal 140. EIT is also realisable using other electron transition schema, such as vee and lambda.

Regardless, the photodetector 125 is arranged downstream of the Rydberg vapour cell 110 (and the second beamsplitter 130-2) in the path of the output signal 150, and is configured to measure, at least, (spectrographic) amplitude of the output signal 150. Depending on the EIT state of the Rydberg atoms, further physical effects can be exploited to detect the EM field 170 from real-time optical measurements of the output signal 150 by the photodetector 125.

Since the outer electron of the Rydberg atom is much further away from the atomic nucleus when in the Rydberg state (|3>) compared to the ground state (|1>), a high polarizability and a large dipole moment (*i.e.* through strong Rabi oscillation) is created. The outer election becomes responsive to the EM field 170 so as to cause a further transition of said electron from the Rydberg state (|3>) to an adjacent Rydberg state (|4>) when the photon energy of the EM field 170 matches the required transition energy (*e.g.* having a frequency of ~3.460GHz), which causes splitting of said states into "dressed states" in a process known as Autler-Townes splitting. In turn, this state splitting causes, by EIT, the Rydberg atoms to become less transparent to the probe laser 140, causing a decrease in amplitude of the output signal 150 to an extent that is proportional to the amplitude of the incident EM field 170. The RAEM-FD 107 is operable to detect the EM field, and in particular Amplitude Modulated (AM) signals, by measuring changes in amplitude of the output signal 150. The publication C. Holloway et al., "A Multiple-Band Rydberg Atom-Based Receiver: AM/FM Stereo Reception" in IEEE Antennas and Propagation Magazine, vol. 63, no. 3, pp. 63-76, June 2021, doi: 10.1109/MAP.2020.2976914, which is herein incorporated by reference, provides details of E-field metrology using Rydberg atom-based techniques (and in particular splitting of the optical transparency region due to the presence of the incident EM field and correlation with EM field amplitude).

Correspondingly, in another example, the RAEM-FD 107 is configured to detect Frequency Modulated (FM) signals. That is, when frequency of the EM field 170 changes (or "detunes") from the frequency required for the transition between the Rydberg state (| 3>) and the adjacent Rydberg state (|4>), EIT resonance again causes Autler-Townes splitting. The separation of the two peaks increases with EM field detuning. By locking the probe laser 115 and coupling laser 120 to particular frequencies, then the output signal 150 is directly correlated to the frequency modulation of the EM field, and spectrographic analysis thereof permits detection of the FM modulation. The publication D. A. Anderson et al., "An Atomic Receiver for AM and FM Radio Communication, " in IEEE Transactions on Antennas and Propagation, vol. 69, no. 5, pp. 2455-2462, May 2021, doi: 10.1109/TAP.2020.2987112, which is herein incorporated by reference, provides a methodology for FM signal detection.

In yet a further example, the RAEM-FD 107 is configured to detect phase modulated EM fields, such as those of Binary Phase-Shift Keying (BPSK), Quadrature Phase-Shift Keying (QPSK), and Quadrature Amplitude Modulation (QAM) signals (used in many wireless and cellular communications protocols). In these modulation schemes, a signal is transmitted by modulating the phase of a carrier signal in the EM field 170. To detect the carrier's phase, a reference EM signal that is on-resonance with the transition to the Rydberg state (|3>) is applied to the Rydberg atoms, which acts as a local oscillator. A difference in frequencies between the carrier and reference EM signals, or the "intermediate frequency", is detected and the phase of the intermediate frequency signal corresponds directly to the relative phase between the local oscillator and the EM field 170.

In any event, the RAEM-FD 107 is configured to detect the specific frequency of the EM field 170 by selecting a particular value of $\lambda_2$ so that electrons of the Rydberg atoms are elevated to a particular Rydberg state (|3>). This particular Rydberg state (|3>) is selected so that photons at the specific frequency of the EM field elevate electrons from this Rydberg state to its adjacent Rydberg state (|4>), which induces a change in the EIT that is then detected by the photodetector 125 from characteristics of the output signal 150.

Regardless of the modulation scheme used (amplitude, frequency and/or phase), to passively improve sensitivity, the RAEM-FD 107 is coupled to the MPWG 105 to form the integrated EM field detector 100.

In a first example, the MPWG 105 is configured as a static stepped-index convergent waveguide lens (herein simply "static lens") 105-1 suitable for focussing the EM field 170 onto the RAEM-FD 107, and specifically the Rydberg vapour cell 110.

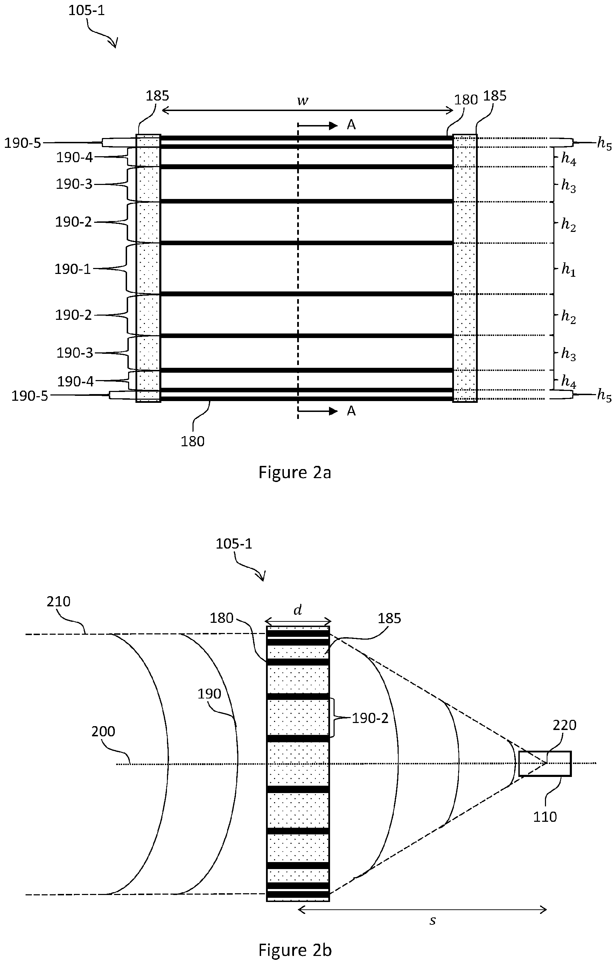

Figures 2a and 2b show the static lens 105-1 in a front elevation and a cross-section along line A-A, respectively. Figure 2b further schematically shows propagation of the EM field 170 through the static lens 105-1 and to the Rydberg vapour cell 110.

The static lens 105-1 comprises a plurality of (exemplarily in Figures 2a and 2b, ten) stacked, and fully overlapping, plates 180 that are each mutually parallel and that are fixed at opposing terminal ends to a pair of endplates 185, thereby forming a ladder-like structure. Each plate 180 is formed of an electric conductor, and in particular a metal (*e.g.* comprising or consisting of Aluminium, Copper, Nickel, Silver and/or Titanium).

Each adjacent pair of plates 180, along with the endplates 185, define an open-ended and air-filled rectangular waveguide 190, and the static lens 105-1 comprises a plurality of (exemplarily in Figures 2a and 2b, nine) waveguides, including a/an: single innermost waveguide 190-1, formed by a pair of the innermost (or centremost) plates; pair of second waveguides 190-2, stacked adjacent both sides of the innermost waveguide 190-1, wherein each of the second waveguides 190-2 share a constituent plate of the first waveguide 190-1; and successive third 190-3, fourth 190-4 and outermost 190-5 pairs of waveguides that further nest outwardly from the innermost 190-1 and second 190-2 waveguides in a corresponding manner.

The pair of plates 180 forming a given waveguide 190 are separated by an inter-pair separation height, $h_i$, where $i$ denotes an index of a given waveguide, such that $i$ = 1, 2, 3, 4 and 5 for the innermost waveguide 190-1, and the pair of second 190-2, third 190-3, fourth 190-4, and outermost 190-5 waveguides, respectively.

The value of $h_i$ dictates the local phase refractive index, $n_i$, of the corresponding $i^{th}$ waveguide/s, according to Equation 1 below:

$$n_i = \sqrt{1 - \left(\frac{c}{2h_i f}\right)^2}$$

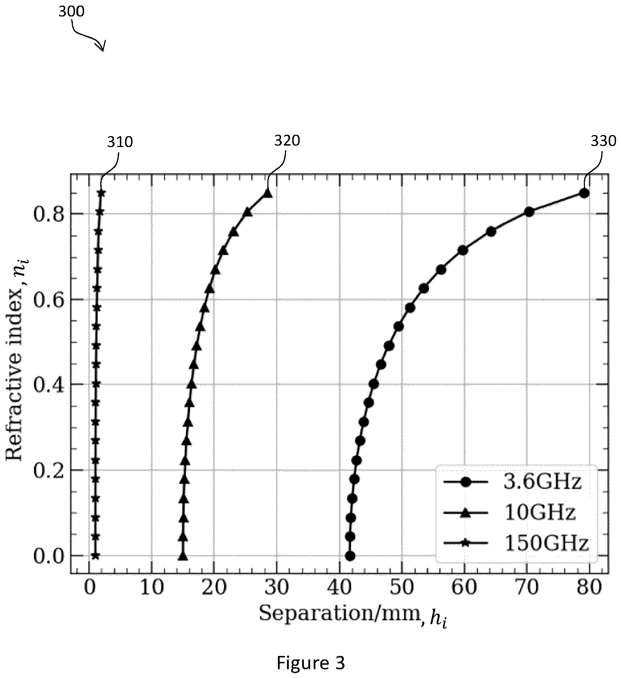

in which, $c$ is the speed of light in a vacuum, and $f$ is a frequency of the incident EM field 170 (which the RAEM-FD 107 is tuned to detect). The refractive index of the media contained within the waveguides 190 has been taken to be 1 (as is substantially appropriate in the present case of the air-filled waveguides in a like atmospheric environment), and is therefore not shown as a term. Figure 3 is a plot illustrating the relationship between $n_i$ and $h_i$ defined by Equation 1 for various sets of values of $f$, and specifically where $f$ = 3.6GHz, 10GHz, and 150GHz, as indicated by reference numerals 310, 320 and 330, respectively.

To configure the static lens 105-1 as a convergent lens, successive adjacent waveguides 190, from the innermost waveguide 190-1 to the outermost waveguides 190-5, are arranged such that the respective value of $h_i$ monotonically decreases, and the values of $n_i$ therefore correspondingly decrease as governed by Equation 1; that is, $h_1 > h_2 > h_3 > h_4 > h_5$, and $n_1 > n_2 > n_3 > n_4 > n_5$.

Values of $h_i$ are selected to achieve a desired refractive index for the value of $f$ (i.e. of the EM field 170), and in turn a desired overall convergent lensing effect achieving a given focal length, $s$. For example, values of $h_i$ are selected to form a stepped-index lens having a profile approximating a parabola or mimicking a section of a hyperbola, ellipse, or circle.

Each waveguide 190 has a width, $w$, which is the lateral extent of each constituent pair of plates 180 between each endplate 185. In the examples of Figures 2a and 2b, $w$ is equal for all waveguides 190. Ideally, $w$ is substantially equal to, or greater than, the wavelength of the EM field 170, with larger values of $w$ increasing the aperture of the static lens 105-1, thereby increasing an energy collection area. Furthermore, the static lens 105-1 is dimensioned such that the values of $h_i$ and $w$ provide waveguides 190 having a waveguide cutoff frequency no less than $f$.

Perpendicularly to $w$ and in the plane of each plate 180, each plate has a depth, $d$, which is equal for all plates, and thus also for all waveguides 190. The value of $d$ is approximately at least equal to the corresponding wavelength for $f$, thereby to create a guided mode (as opposed to inducing diffractive effects) for, at least, the constituent E-field of the EM field 170. To help reduce scattering, each plate 180 is dimensioned to have minimal thickness (e.g. less than 2mm or so).

The static lens 105-1 is separated from the Rydberg vapour cell 110 by the focal length, $s$, of said lens for $f$, such that a focal line (i.e. extending, at $s$, parallel to $w$) of the static lens 105-1 lies within, and ideally at a centre of, the Rydberg vapour cell 110.

Figure 2b illustrates propagation of the EM field 170 through the static lens 105-1, represented schematically by ray lines 210 (shown with long-dash lines). The EM field 170 propagating through the static lens 105-1 effectively bends towards the region having the greatest refractive index, i.e. $n_1$, and specifically towards a plane 200 (shown in profile with dotted lines) bisecting - parallel to the constituent plates 180 of - the innermost waveguide 190-1.

The static lens 105-1 causes the EM field 170 to converge to the focal line 220 within the plane 200. The innermost waveguide 190-1, and therefore the plane 200, is arranged in alignment with the Rydberg vapour cell 110, such that said plane bisects said cell. All else being equal, $s$ is dictated by the selected values of $h_i$, and by $f$. The static lens 105-1 and a centre of the Rydberg vapour cell 110 are separated by the ensuing value of $s$, thereby to arrange the Rydberg vapour cell 110 at the focal line 220 for the EM field 170. In this way, the static lens 105-1 effectively focuses the EM field 170 (or, at least, a component having a frequency of $f$) onto the Rydberg vapour cell 110, thereby increasing sensitivity of the RAEM-FD 107.

Various parameters of the EM field 170 (e.g. beam diameter, collimation, and angle of incidence) affect $s$, as well as associated focal parameters (e.g. focal depth and diameter). To improve efficacy, the MPWG lens 105 is also orientated towards and aligned with the EM source 175, such that the EM field 170 is caused to propagate within the waveguides 190 and is focussed onto the RAEM-FD.

For example, dimensions of the innermost waveguide 190-1 are: $h_1$= 29mm (and successively decreasing by 2mm with each successive waveguide, i.e. such that $h_5$ = 21 mm); $w$ = 800mm; and $d$= 36mm. At such dimensions, the static lens 105-1 is therefore suitable for focussing the EM field 170 in which *f*=10GHz (which, for the RAEM-FD 107, corresponds with the transition $^{61}D_{5/2}$ to $^{60}F_{7/2}$ of Rubidium-85); in this case, *s* = 180mm. Where the EM field 170 has a beam diameter of 300mm, a depth of field of approximately 90mm results.

Advantageously, the static lens 105-1 (and the MPWG 105 more generally) also has the effect of helping selectively filter-out interference at or below the cutoff frequency of the constituent waveguides 190.

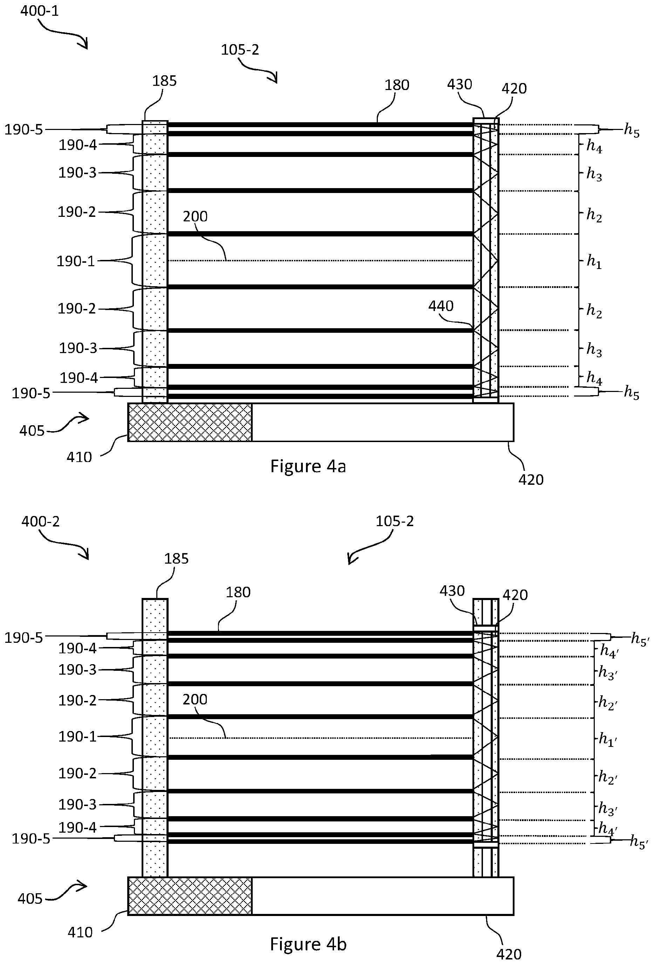

Figures 4a and 4b schematically show a second example of the MPWG 105 formed as a tuneable stepped-index convergent waveguide lens (herein simply "tuneable lens") 105-2. The tuneable lens 105-2 is akin to the static lens 105-1, with the addition of a mechanism for adjusting $h_i$, as described below. Accordingly, like features of the tuneable lens 105-2 to those of the static lens 105-1 are described below with reference to, and as shown in, Figures 4 using identical reference numerals.

Figure 4a shows the tuneable lens 150-2 in a first configuration 400-1, and Figure 4b shows the lens 150-2 in a second configuration 400-2. The lens 105-2 further comprises a tuning system 405 that in turn comprises a controller 410 and an actuation mechanism 420. The controller is in the form of a logical processor (*e.g.* an Application Specific Integrated Circuit) and a power supply *(e.g.* a/an battery, energy harvester, or electrical connector for connecting to a power source). The controller is coupled to the actuation mechanism 420 so as to power and control operation of said mechanism.

The actuation mechanism 420 is configured to move the plurality of plates 180 so as to compress and expand $h_i$. In this specific example, the actuation mechanism 420 is configured to vary $h_i$ whilst maintaining constant relative proportions of $h_i$, and maintaining the innermost waveguide 190-1 aligned with the Rydberg vapour cell 110.

To do so, in one example, the actuation mechanism 420 comprises a variable pitch spring 420 and a motorised clamp 430. Each of the plurality of plates 180 is fixed to the variable pitch spring 420 at an anchor point 440 such that the plates mimic the movement of the corresponding anchor point of the variable pitch spring 420 as said spring compresses and expands. The motorised clamp 430 is configured to compress the variable pitch spring 420. Upon widening the clamp 430, the spring decompresses.

In the first configuration 400-1, the variable pitch spring 420 is in an uncompressed state, which is achieved by widening the motorised clamp 120. In this configuration 400-1, the plurality of plates 180 and anchor points 440 are arranged as per the static lens 105-1 (*i.e.* such that the waveguides 190 have heights $h_1$, $h_2$, $h_3$, $h_4$, and $h_5$).

In the second configuration 400-2, the variable pitch spring 420 is in a compressed state, which is achieved by actuating the motorised clamp to compress said spring. In this configuration 400-2, the plates 180 are compressed about plane 200 such that the innermost 190-1, second 190-2, third 190-3, fourth 190-4 and outermost 190-5 waveguides each have a reduced height, $h_i$, compared to the corresponding heights when in the first configuration 400-1, and of $h_1$, $h_2$, $h_3$, $h_4$, and $h_5$ respectively; that is,

$$\frac{h_{i'}}{h_i} = a$$

, where $1 > a > 0$.

It will be appreciated that the actuation mechanism 420 shown in, and described with reference to, Figures 4a and 4b is purely exemplary and that numerous other forms of mechanisms are readily apparent to the person skilled in the art, including coupling each plate to a corresponding dedicated motorised linear actuator.

Regardless of the specific form of the actuation mechanism 420, the tuning system 405 permits variation of $h_i$ so as to counteract misalignment of the focal line 220 with the Rydberg vapour cell 110. As per *Equation 1,* and as illustrated in Figure 3, $n_i$ of each waveguide 190 is dependent upon *f,* thus the value of *s* (and waveguide cutoff frequency) changes with *f.* Accordingly, all else being equal, increases in *f* cause s also to increase, and sufficient increases (or decreases) in *f* will therefore cause the focal line overshoot (or fall short of) the Rydberg vapour cell 110, disenabling improvements to sensitivity of the RAEM-FD 107.

The tuneable lens 105-2 is re-configurable to maintain a value of *s* such that the focal line 220 of said lens is coincident upon the Rydberg vapour cell 110 with changes in *f* (especially in the case of a FM signal), thereby helping maintain an improvement in sensitivity across a wider range of *f.*

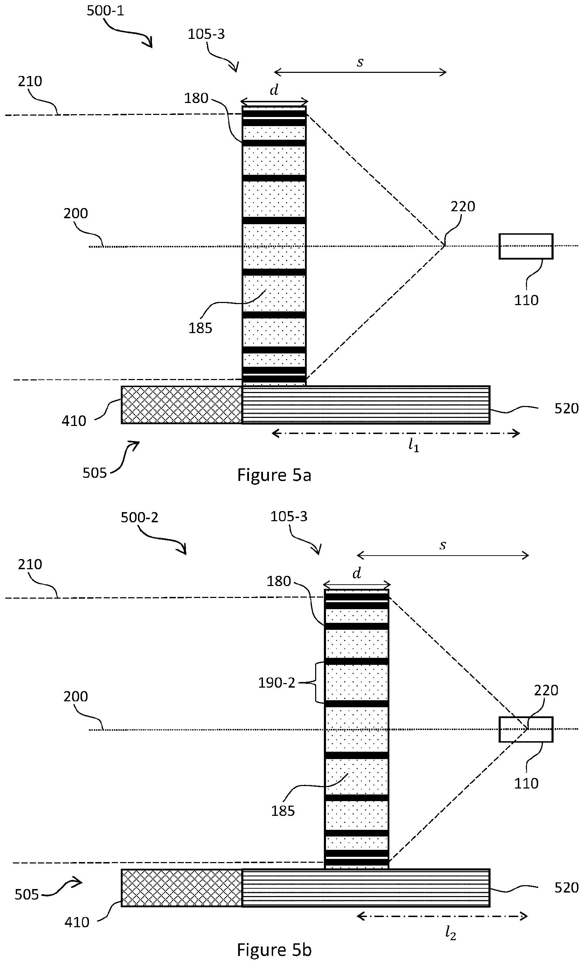

Figures 5a and 5b show a third example of the MPWG 105 formed as a translatable stepped-index convergent waveguide lens (herein simply "translatable lens") 105-3. The translatable lens 105-3 is akin to the static lens 105-1, with the addition of a translation system 505. Accordingly, like features of the translatable lens 105-3 to those of the static lens 105-1 are described below with reference to, and shown in, Figures 5 using identical reference numerals.

The translation system 505 comprises the controller 410 and a translation mechanism 520. In this example, the controller 410 is coupled to the translation mechanism 520 so as to power and control operation of said mechanism.

Figure 5a shows the translatable lens 150-3 in a first configuration 500-1, and Figure 5b shows the lens 150-3 in a second configuration 500-2.

The waveguides 190 and endplates 185 are coupled to the translation mechanism 520 so as to be translated towards and away from the Rydberg vapour cell 110 parallel to the plane 200 and along the path of propagation of the EM field 170 through the translatable lens 105-3. For example, the translation mechanism 520 is in the form of a linear actuator or conveyor belt.

In the first configuration 500-1, the translation mechanism 520 is configured to locate the translatable lens 105-3 at $l_1$, such that the focus line 220 falls outside of the Rydberg vapour cell 110 (*i.e.* $l_1 \neq s$) for *f*.

In the second configuration 500-2, the translation mechanism 520 is re-configured to locate the lens 105-3 at $l_2$, in which the focus line 220 falls centrally within the Rydberg vapour cell 110 (*i.e.* $l_1 = s$) for *f*.

Accordingly, the lens 105-3 is configured to bodily move the translatable lens 105-3 so as to refocus said lens onto the Rydberg vapour cell 110 with changes in *f*.

It will be appreciated that the principles of the tuneable lens 105-2 of Figures 4, and the translatable lens 105-3 of Figures 5 are available to be combined, such that an ensuing - herein "trans-tuneable" - lens is both translatable and tuneable, thereby providing two modes (used simultaneously or alternatively) for re-focussing.

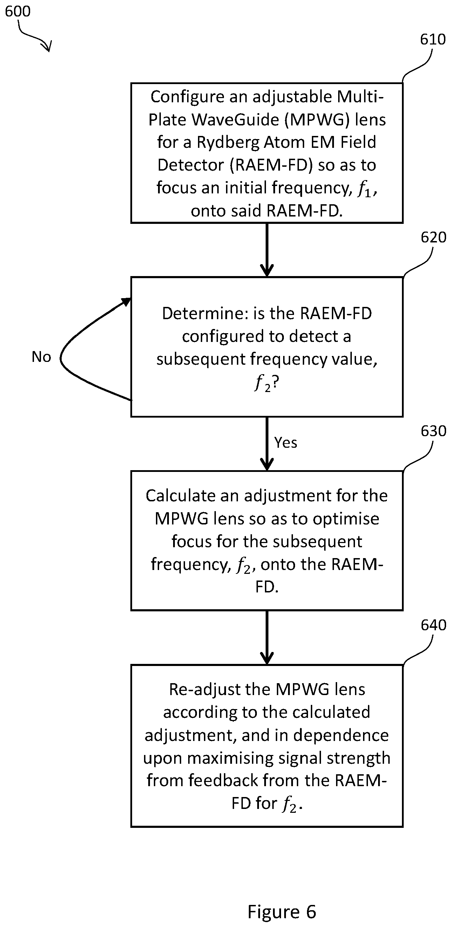

Figure 6 shows a tuning process 600 suitable for operating the tuneable 105-2, translatable 105-3, and trans-tuneable lenses (herein collectively referred to as the "adjustable lens") in order dynamically to maintain focus of the EM field 170 upon the Rydberg vapour cell 110.

At a first step 610, the adjustable lens is provided in a state (*i.e.* with appropriately set parameters $h_i$ and/or *l*) so as to focus onto the Rydberg vapour cell 110 an initial frequency, $f_1$, of the EM field 170 that the RAEM-FD is configured to detect (*e.g.* as pre-defined or measured by the RAEM-FD).

At a next step 620, the controller 410 determines whether the RAEM-FD 107 is re-configured (*e.g.* by changes to the lasers 115, 125 and/or to a local oscillator, if provided) to detect a subsequent frequency value, $f_2$, in which $f_1 \neq f_2$ (*e.g.* as per a pre-scheduled change in frequency, or as detected by the RAEM-FD). If not, step 620 is repeated after a pre-determined period.

If, instead, at step 620 it is determined by the controller 410 that the RAEM-FD 107 is configured to detect $f_2$, then, at a next step 630, the controller 410 calculates (including by estimation or heuristics) a corresponding change in parameter/s of the adjustable lens (*i.e.* $h_i$ and/or *l*) suitable for re-focussing the adjustable lens onto the Rydberg vapour cell 110 for the change from $f_1$ to $f_2$.

At a next step 640, the controller 410 operates the actuation mechanism 420 and/or translation mechanism 520 so as to effect the calculated change in parameter, and in a feedback process with the RAEM-FD 107, adjustment thereof is also controlled in dependence upon maximising signal strength of the EM field 170 at $f_2$ as detected by the RAEM-FD 107.

In the specific case where the adjustable lens is in the form of the trans-tuneable lens (*i.e.* comprising both the actuation mechanism 420 and the translation mechanism 520), and when $|f_2 - f_1| \leq f_t$, in which $f_t$ is a threshold value for a small frequency change, then at step 640 only the translation mechanism 520 is operated (*i.e.* to change only *l*, as per the transition from the first configuration 500-1 to the second configuration 500-2), otherwise (*i.e.* when $|f_2 - f_1| \geq f_t$), then only the actuation mechanism 520 is operated (*i.e.* to change only $h_i$, as per the change from the first configuration 400-1 to the second configuration 400-2).

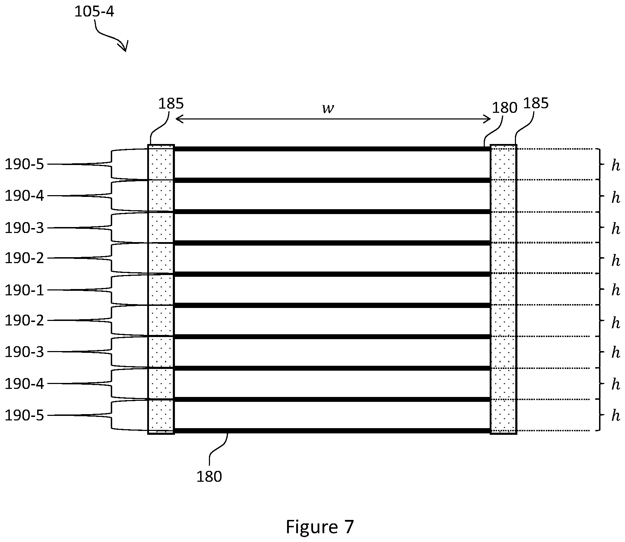

Figure 7 show a fourth example of the MPWG 105 formed as a non-lensing waveguide 105-4, in which the static lens 105-1 is modified such that each of the waveguides 190 all having the same value of $h_i$. Accordingly, like features of the non-lensing waveguide 105-4 to those of the static lens 105-1 are described below with reference to, and shown in, Figures 5 using identical reference numerals.

The non-lensing waveguide 105-4 is centrally aligned with the Rydberg vapour cell 110, and the waveguides are dimensioned with a value of $h_i$ so as to permit guided propagation of the EM field 170 (specifically, at least, the constituent E-field) towards the Rydberg vapour cell 110 (*i.e.* such that the waveguide cutoff frequency is less than *f*).

The non-lensing waveguide 105-4 confines propagation of the EM-field 170 thereby helping to constrain power of the propagating EM field, and thus help increase sensitivity of the RAEM-FD.

To remain effective as a waveguide or a lens at low frequencies, the various MPWG 105 described above become impractically large. However, when the RAEM-FD 107 is configured and operated to be ultra-wideband (e.g. with appropriate control of lasers 115, 120, and/or a local oscillator, if provided), the MPWG 105 can remain small and permit increased sensitivity at high frequencies detectable by the RAEM-FD, whilst simultaneously causing negligible detriment to detection of low frequencies by the same RAEM-FD.

### Alternatives and Modifications

It will be appreciated that the MPWG 105 is available to have any number of the waveguides 190. For example, the static 105-1 and adjustable lens are available to comprise at least two waveguides (and where there are only two waveguides, the constituent waveguide having the largest inter-pair height is taken as the innermost waveguide 190-1).

In another example, the MPWG is available to comprise an odd or even number of waveguides 190 (and in the latter case, as applied to the static 105-1 or adjustable lens, there are consequently two innermost waveguides 190-1). For the same values of $h_i$, more waveguides 190 provide a larger aperture. In the case of the static 105-1 and adjustable lenses, more waveguides permit a smoother index-stepped lens to be formed.

Although the examples of the static 105-1 and the adjustable lenses are shown as symmetric about plane 200, it will be appreciated that asymmetric forms are also adoptable, such that there are a different number of waveguides 190 and/or different values of $h_i$ on one side of the innermost waveguide 190-1 than on the other side. For example, the inter-pair height is available to decrease monotonically from one end to the other end of said lenses.

In yet another example of the static 105-1 and/or adjustable lens, the value of $h_i$ is available to vary in any manner (alternative to the aforementioned monotonic variation) to provide an intended lensing effect, including as a complex lens having non-monotonic variation of $h_i$.

In a more specific alternative, the static 105-1 and/or adjustable lens is/are instead configured as a divergent lens by instead monotonically increasing $h_i$ from the innermost waveguide 190-1 to the outermost waveguides 190-5 (and $n_i$ correspondingly). Such a divergent lens may help filter interference from reaching the RAEM-FD 107. The divergent lens is available to be provided additionally (*e.g.* in series, before and/or after), or alternatively to, the static lens 105-1, adjustable lens, and/or the non-lensing waveguide 105-4.

In an alternative, at least one pair of plates 180, forming a given at least one waveguide 190, are inclined (but non-intersecting), rather than parallel, so as to form a mouth and throat distally and proximally to the Rydberg vapour cell 110, respectively. In this way, said given at least one waveguide 190 is tapered and forms a horn, increasing the aperture size of said waveguide.

In an alternative to the example of Figure 7, the non-lensing waveguide 105-4 additionally comprises the tuning system 405 so as to vary the value of $h_i$ (*e.g.* to maintain the waveguide cutoff frequency below the value of *f* that is sought to be detected). In a more specific example, the tuning system 405 is configured and operated so as to maintain $h_i$ equal for all waveguides (*e.g.* such that the variable pitch spring 420 is instead a constant pitch spring). In an alternative specific example, the tuning mechanism 405 is configured and operated to provide differential variation of $h_i$ for different waveguides (*e.g.* where dedicated actuators are provided for each waveguide 190), in which case the tuning system 405 effectively permits re-configuration between the non-lensing waveguide 105-4 and the tuneable lens 105-2.

It will be appreciated that the EM field detector 100 is available to incorporate alternative forms of the RAEM-FD 107 that are apparent to the person skilled in the art, especially having alternative quantum (*e.g.* as to the selected Rydberg atom and electron transitions, and the operation of the lasers 115, 120) and optical (*e.g.* absent the first beamsplitter 130-1, such that the probe laser 115 is directly aligned with the Rydberg vapour cell 110) configurations.

In one embodiment, the system and/or its components or subsystems can include computing devices, microprocessors, modules and other computer or computing devices, which can be any programmable device that accepts digital data as input, is configured to process the input according to instructions or algorithms, and provides results as outputs. In one embodiment, computing and other such devices discussed herein can be, comprise, contain or be coupled to a Central Processing Unit (CPU) configured to carry out the instructions of a computer program. Computing and other such devices discussed herein are therefore configured to perform basic arithmetical, logical, and input/output operations.

Computing and other devices discussed herein can include memory. Memory can comprise volatile or non-volatile memory as required by the coupled computing device or processor to not only provide space to execute the instructions or algorithms, but to provide the space to store the instructions themselves. In one embodiment, volatile memory can include random access memory (RAM), dynamic random access memory (DRAM), or static random access memory (SRAM), for example. In one embodiment, non-volatile memory can include read-only memory, flash memory, ferroelectric RAM, hard disk, floppy disk, magnetic tape, or optical disc storage, for example. The foregoing lists in no way limit the type of memory that can be used, as these embodiments are given only by way of example and are not intended to limit the scope of the disclosure.

In one embodiment, the system or components thereof can comprise or include various modules or engines, each of which is constructed, programmed, configured, or otherwise adapted to autonomously carry out a function or set of functions. The term "engine" as used herein is defined as a real-world device, component, or arrangement of components implemented using hardware, such as by an application specific integrated circuit (ASIC) or field programmable gate array (FPGA), for example, or as a combination of hardware and software, such as by a microprocessor system and a set of program instructions that adapt the engine to implement the particular functionality, which (while being executed) transform the microprocessor system into a special-purpose device. An engine can also be implemented as a combination of the two, with certain functions facilitated by hardware alone, and other functions facilitated by a combination of hardware and software. In certain implementations, at least a portion, and in some cases, all, of an engine can be executed on the processor(s) of one or more computing platforms that are made up of hardware (*e.g.*, one or more processors, data storage devices such as memory or drive storage, input/output facilities such as network interface devices, video devices, keyboard, mouse or touchscreen devices, etc.) that execute an operating system, system programs, and application programs, while also implementing the engine using multitasking, multithreading, distributed (e.g., cluster, peer-peer, cloud, etc.) processing where appropriate, or other such techniques. Accordingly, each engine can be realized in a variety of physically realizable configurations, and should generally not be limited to any particular implementation exemplified herein, unless such limitations are expressly called out. In addition, an engine can itself be composed of more than one sub-engines, each of which can be regarded as an engine in its own right. Moreover, in the embodiments described herein, each of the various engines corresponds to a defined autonomous functionality; however, it should be understood that in other contemplated embodiments, each functionality can be distributed to more than one engine. Likewise, in other contemplated embodiments, multiple defined functionalities may be implemented by a single engine that performs those multiple functions, possibly alongside other functions, or distributed differently among a set of engines than specifically illustrated in the examples herein.

Various embodiments of systems, devices, and methods have been described herein. These embodiments are given only by way of example and are not intended to limit the scope of the claimed inventions. It should be appreciated, moreover, that the various features of the embodiments that have been described may be combined in various ways to produce numerous additional embodiments. Moreover, while various materials, dimensions, shapes, configurations and locations, etc. have been described for use with disclosed embodiments, others besides those disclosed may be utilized without exceeding the scope of the claimed inventions.

Persons of ordinary skill in the relevant arts will recognise that embodiments may comprise fewer features than illustrated in any individual embodiment described above. The embodiments described herein are not meant to be an exhaustive presentation of the ways in which the various features may be combined. Accordingly, the embodiments are not mutually exclusive combinations of features; rather, embodiments can comprise a combination of different individual features selected from different individual embodiments, as understood by persons of ordinary skill in the art. Moreover, elements described with respect to one embodiment can be implemented in other embodiments even when not described in such embodiments unless otherwise noted. Although a dependent claim may refer in the claims to a specific combination with one or more other claims, other embodiments can also include a combination of the dependent claim with the subject matter of each other dependent claim or a combination of one or more features with other dependent or independent claims. Such combinations are proposed herein unless it is stated that a specific combination is not intended. Furthermore, it is intended also to include features of a claim in any other independent claim even if this claim is not directly made dependent to the independent claim.

Moreover, reference in the specification to "one embodiment," "an embodiment," or "some embodiments" means that a particular feature, structure, or characteristic, described in connection with the embodiment, is included in at least one embodiment of the teaching. The appearances of the phrase "in one embodiment" in various places in the specification are not necessarily all referring to the same embodiment.

Any incorporation by reference of documents above is limited such that no subject matter is incorporated that is contrary to the explicit disclosure herein. Any incorporation by reference of documents above is further limited such that no claims included in the documents are incorporated by reference herein. Any incorporation by reference of documents above is yet further limited such that any definitions provided in the documents are not incorporated by reference herein unless expressly included herein.

Each feature disclosed herein, and (where appropriate) as part of the claims and drawings may be provided independently or in any appropriate combination.

Any reference numerals appearing in the claims are for illustration only and shall not limit the scope of the claims.

## Claims

1. An apparatus for detecting an Electro-Magnetic, EM, field, said apparatus comprising a:

   Rydberg-Atom EM Field Detector, RAEM-FD, configured to detect an EM field of a given frequency; and
   Multi-Plate WaveGuide, MPWG, comprising:

   at least three overlapping and non-intersecting plates; and
   at least two waveguides, each formed by an adjacent pair of the at least three plates, and wherein each waveguide has a separation distance suitable for supporting propagation of the EM field; and

   wherein the MPWG is arranged so as to direct the EM field towards the RAEM-FD.

2. An apparatus according to Claim 1, wherein the at least two waveguides are configured such that the separation distances decrease with successive waveguides, thereby to configure the MPWG as a stepped-index convergent lens having a focus for the given frequency, and wherein the MPWG is arranged so that the focus is coincident upon the RAEM-FD.

3. An apparatus according to Claim 1, wherein the at least two waveguides plates are configured such that the separation distances increase with successive waveguides, thereby to configure the MPWG as a stepped-index divergent lens.

4. The apparatus according to any preceding claim, wherein the separation distances are equal for at least two of the at least two waveguides.

5. The apparatus according to any preceding claim, wherein all, or at least two, of the at least three plates are mutually parallel.

6.  The apparatus according to any preceding claim, further comprising an actuation mechanism, said mechanism in turn comprising at least one of a:

    first actuator configured to move at least one of the at least three plates so as to change the separation distance of at least one of the at least two waveguides that is associated with said at least one plate; and
    second actuator configured bodily to move the MPWG and/or the RAEM-FD so as to change a spacing therebetween along an axis parallel to the propagation of the EM field through the MPWG.

7.  The apparatus according to Claim 6, further comprising a controller configured to tune the RAEM-FD to detect a further EM field of a further given frequency, different to the given frequency, and wherein the controller is further configured to operate the actuation mechanism so as to reconfigure the apparatus so as to direct the further EM field towards the RAEM-FD.

8.  The apparatus according to Claim 7 when dependent upon Claim 2, wherein the controller is configured to operate the actuation mechanism so as to focus the further EM field upon the RAEM-FD.

9.  The apparatus according to Claim 8, wherein the controller is configured to receive, from the RAEM-FD, a reading of signal strength for the further EM-field, and wherein the controller is configured responsively to operate the actuation mechanism in dependence upon increasing said received signal strength.

10. A radio receiver for a wireless telecommunications network comprising the apparatus according to any preceding claim.

11. A method of operating an apparatus for detecting an Electro-Magnetic, EM, field, said apparatus comprising a/an:

    Rydberg-Atom EM Field Detector (RAEM-FD) configured to detect an EM field of a given frequency;
    Multi-Plate WaveGuide, MPWG, comprising:

    at least three overlapping and non-intersecting plates; and
    at least two waveguides, each formed by an adjacent pair of the at least three plates, and wherein each waveguide has a separation distance suitable for supporting propagation of the EM field, wherein the MPWG is arranged so as to direct the EM field towards the RAEM-FD;

    actuation mechanism comprising at least one of a:

    first actuator configured to move at least one of the at least three plates so as to change the separation distance of at least one of the at least two waveguides that is associated with said at least one plate; and
    second actuator configured bodily to move the MPWG and/or the RAEM-FD so as to change a spacing therebetween along an axis parallel to the propagation of the EM field through the MPWG; and

    controller configured to tune the RAEM-FD to detect a further EM field of a further given frequency, different to the given frequency, and wherein the controller is further configured to operate the actuation mechanism so as to reconfigure the apparatus so as to direct the further EM field towards the RAEM-FD;

    the method comprising the steps of:

    providing the RAEM-FD in a first condition suitable for detecting the given frequency;
    providing the first actuator and/or the second actuator in a first state suitable for directing the EM field towards the RAEM-FD;
    re-tuning, by the controller, the RAEM-FD into a second conditions suitable for detecting the further given frequency; and
    re-configuring, by the controller and in response to said re-tuning, the first actuator and/or the second actuator into a second state suitable for directing the further EM field towards the RAEM-FD.

12. A computer-readable carrier medium comprising a computer program, which, when the computer program is executed by a computer, causes the computer to carry out the steps of Claim 11.

Figure 1

Figure 2a

Figure 2b

Figure 3

400-1

105-2

185     180     430     420

190-5

190-4                                                                    $h_5$

190-3                                                                    $h_4$

190-2                                                                    $h_3$

190-1                                     200                            $h_2$

                                                                        $h_1$

190-2                                                        440         $h_2$

190-3                                                                    $h_3$

190-4                                                                    $h_4$

190-5                                                                    $h_5$

405

410

Figure 4a

420

400-2

105-2

185     180     430     420

190-5

190-4                                                                    $h_{5'}$

190-3                                                                    $h_{4'}$

190-2                                     200                            $h_{3'}$

190-1                                                                    $h_{2'}$

                                                                        $h_{1'}$

190-2                                                                    $h_{2'}$

190-3                                                                    $h_{3'}$

190-5                                                                    $h_{4'}$

                                                                        $h_{5'}$

405

410

Figure 4b

420

Figure 5a

Figure 5b

600

610

Configure an adjustable Multi-Plate WaveGuide (MPWG) lens for a Rydberg Atom EM Field Detector (RAEM-FD) so as to focus an initial frequency, $f_1$, onto said RAEM-FD.

620

Determine: is the RAEM-FD configured to detect a subsequent frequency value, $f_2$?

No

Yes

630

Calculate an adjustment for the MPWG lens so as to optimise focus for the subsequent frequency, $f_2$, onto the RAEM-FD.

640

Re-adjust the MPWG lens according to the calculated adjustment, and in dependence upon maximising signal strength from feedback from the RAEM-FD for $f_2$.

Figure 6

105-4

185                    w                    180 185

190-5 —                                              h
190-4 —                                              h
190-3 —                                              h
190-2 —                                              h
190-1 —                                              h
190-2 —                                              h
190-3 —                                              h
190-4 —                                              h
190-5 —                                              h

180

Figure 7

Europäisches
Patentamt

European
Patent Office

Office européen
des brevets

# EUROPEAN SEARCH REPORT

**Application Number**

EP 24 17 9958

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 115 184 693 A (PEOPLE'S LIBERATION ARMY NATIONAL UNIVERSITY OF DEFENSE TECHNOLOGY) 14 October 2022 (2022-10-14) | 1,4,5,10 | INV. G01R29/08 H04B10/00 |
| A | * paragraphs [0003], [0014] - [0032]; claims 1-7; figures 1-5 * | 2,3,6-9, 11,12 | |
| | ----- | | |
| X | US 11 977 107 B1 (YU SU-PENG [CA] ET AL) 7 May 2024 (2024-05-07) | 1,4,5,10 | |
| A | * column 24 - column 28; claims 1-30; figures 14A-15F * | 2,3,6-9, 11,12 | |
| | ----- | | |
| X | US 2020/233025 A1 (SALIM EVAN [US] ET AL) 23 July 2020 (2020-07-23) | 1,4,5,10 | |
| A | * paragraphs [0003] - [0072]; claims 1-19; figures 1-11B * | 2,3,6-9, 11,12 | |
| | ----- | | |
| X | CN 117 871 969 A (CHENGDU TIGER MICROELECTRONICS RES INSTITUTE CO LTD) 12 April 2024 (2024-04-12) | 1,4,5,10 | |
| A | * paragraphs [0034] - [0065]; claims 1-5; figures 1-15 * | 2,3,6-9, 11,12 | TECHNICAL FIELDS SEARCHED (IPC) |
| | ----- | | G01R H04B |

The present search report has been drawn up for all claims

| Place of search | Date of completion of the search | Examiner |
|---|---|---|
| Munich | 25 October 2024 | Bilzer, Claus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.....................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 9958

This annex lists the patent family members relating to the patent documents cited in the above-mentioned European search report.
The members are as contained in the European Patent Office EDP file on
The European Patent Office is in no way liable for these particulars which are merely given for the purpose of information.

25-10-2024

| Patent document cited in search report | | Publication date | Patent family member(s) | Publication date |
|---|---|---|---|---|
| CN 115184693 | A | 14-10-2022 | NONE | |
| US 11977107 | B1 | 07-05-2024 | NONE | |
| US 2020233025 | A1 | 23-07-2020 | NONE | |
| CN 117871969 | A | 12-04-2024 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **C. HOLLOWAY et al.** A Multiple-Band Rydberg Atom-Based Receiver: AM/FM Stereo Reception. *IEEE Antennas and Propagation Magazine*, June 2021, vol. 63 (3), 63-76

- **D. A. ANDERSON et al.** An Atomic Receiver for AM and FM Radio Communication. *IEEE Transactions on Antennas and Propagation*, May 2021, vol. 69 (5), 2455-2462